(19) Europäisches Patentamt / European Patent Office / Office européen des brevets

(11) **EP 1 747 849 A1**

(12) **EUROPEAN PATENT APPLICATION**
published in accordance with Art. 158(3) EPC

(43) Date of publication:
**31.01.2007 Bulletin 2007/05**

(51) Int Cl.:
**B24B 37/00** (2006.01)  **C09K 3/14** (2006.01)
**H01L 21/304** (2006.01)

(21) Application number: **05739353.0**

(22) Date of filing: **16.05.2005**

(86) International application number:
**PCT/JP2005/008890**

(87) International publication number:
**WO 2005/110679 (24.11.2005 Gazette 2005/47)**

(84) Designated Contracting States:
**DE FR GB IT NL**

(30) Priority: **19.05.2004 JP 2004148819**

(71) Applicant: **Nissan Chemical Industries, Ltd.**
**Chiyoda-ku,**
**Tokyo 101-0054 (JP)**

(72) Inventors:
• OTA, Isao; c/o Nissan Chemical Industries, Ltd.
Sa sakura, Fuchu-machi, Toyama-shi (JP)

• **TANIMOTO, Kenji; c/o Nissan Chemical Industries,**
**6 35, Sasakura, Fuchu-machi, Toyama (JP)**
• **TAKAKUMA, Noriyuki; c/o Nissan Chemical Lab**
**635, Sas kura**
**Fuchu-machi**
**Toyama (JP)**

(74) Representative: **HOFFMANN EITLE**
**Patent- und Rechtsanwälte**
**Arabellastrasse 4**
**81925 München (DE)**

(54) **COMPOSITION FOR POLISHING**

(57)    [Problems] To provide a polishing agent for use in polishing for planarization in semiconductor device production steps and for use in a semiconductor device isolation process.

[Means for solving Problems]

The composition for polishing comprises a component (A), which is a water-soluble organic compound containing a carboxyl group or a salt thereof; and a component (B), which is an aqueous sol of cerium oxide particles obtained by calcining a cerium compound by holding it in at least two different calcining temperature ranges and wet-milling the resultant cerium oxide powder until the ratio of the mean particle size (b1) measured in the aqueous sol by the laser diffraction method to the particle size (b2) as determined from the specific surface area measured by the gas adsorption method is in the range of either 1 to 4 or 15 to 40. The component (A) is ammonium acrylate, ammonium methacrylate, an amino acid or a derivative thereof. The component (B) is obtained by a process in which the cerium compound is calcined by holding it in two calcining temperature ranges, that is, a range of 200 to 350°C and a range of 400 to 550°C or 700 to 850°C, and the resultant cerium oxide powder is wet-milled.

EP 1 747 849 A1

## EP 1 747 849 A1

**Description**

TECHNICAL FIELD

The present invention relates to a composition for polishing that contains crystalline cerium oxide particles.

BACKGROUND ART

A method has been described for polishing $SiO_2$, SiON, SiOF, borophosphosilicate glass, and phosphosilicate glass on a semiconductor device substrate using an abrasive material that includes abrasive particles, in which the main component is cerium oxide, and a surface active agent that is an organic compound having COOH (a carboxyl group) or COOM, (M, being an atom or functional group that replaces the hydrogen atom in the carboxyl group and is capable of forming a salt). (Patent Document 1)

An abrasive material made up of ceria and a polymeric acid such as polyacrylic acid or the like has also been disclosed. (Patent Document 2)

Ammonium acrylate with a weight average molecular weight of 5,000 to 20,000 has been described as a satisfactory dispersing agent for a cerium oxide abrasive material. (Patent Document 3)

A cerium oxide abrasive material has also been disclosed that contains cerium oxide particles, a copolymer of an ammonium acrylate salt and methyl acrylate with a weight average molecular weight of 1,000 to 20,000, and water. (Patent Document 4)

A cerium oxide abrasive material has also been disclosed that contains cerium oxide particles with a mean particle size of 200 to 400 nm, as measured in liquid by the laser diffraction method. (Patent Document 5)

An aqueous sol has been described that contains near-monodisperse crystalline cerium oxide (IV) particles with a particle size of 10 to 200 nm, as determined from the specific surface area measured by the gas adsorption method, and a value from 2 to 6 for the ratio of the mean particle size measured in the aqueous sol by the dynamic light scattering method to the particle size as determined from the specific surface area measured by the gas adsorption method. (Patent Document 6)

A slurry has been disclosed that contains cerium oxide particles obtained by calcination of cerium carbonate and having a specific surface area of at least 25 $m^2/g$ (i.e., a particle size of 33 nm or smaller as determined from the specific surface area measured by the gas adsorption method). (Patent Document 7)

A composition for polishing has been disclosed that contains cerium oxide that uses an amino acid type of surface active agent. (Patent Documents 8 and 9)

A method of manufacturing cerium oxide from cerium carbonate by a multiple-step temperature rise process that includes a temperature rise step of heating at a rate of temperature rise of 2 to 60°C per hour has been disclosed. (Patent Document 10)

Patent Document 1: Japanese Patent Publication No. JP-B-3278532 (Claims, Examples)
Patent Document 2: Japanese Patent Publication No. JP-B-3130279 (Claims)
Patent Document 3: Japanese Patent Application Publication No. JP-A-10-152673 (Specification)
Patent Document 4: Japanese Patent Publication No. JP-B-3480323 (Claims)
Patent Document 5: Japanese Patent Publication No. JP-B-3462052 (Claims)
Patent Document 6: Japanese Patent Application Publication No. JP-A-2002-326812 (Claims, Examples)
Patent Document 7: Japanese Patent Application Publication No. JP-A-10-106986 (Claims)
Patent Document 8: Japanese Patent Application Publication No. JP-A-2001-31951 (Claims)
Patent Document 9: Japanese Patent Application Publication No. JP-A-2003-55648 (Claims)
Patent Document 10: PCT Publication No. WO2004-037722 (Claims)

DISCLOSURE OF THE INVENTION

Problem to be Solved by the Invention

In Patent Document 1 and Patent Document 2, cerium oxide abrasive materials are disclosed that contain ammonium polyacrylate or polyacrylic acid, but no descriptions of the average molecular weight of polyacrylic acid are provided.

In Patent Document 3, a weight average molecular weight of 5,000 to 20,000 is described for an ammonium polyacrylate salt.

In Patent Document 7, a specific surface area of at least 25 $m^2/g$ (i.e., a particle size of 33 nm or smaller as determined from the specific surface area measured by the gas adsorption method) for cerium oxide particles is described.

A slurry is also described in which cerium oxide particles with a specific surface area of 144 m$^2$/g (i.e., a particle size of 6 nm as determined from the specific surface area) are dispersed in water and an ammonium polyacrylate salt and wherein the mean particle size of the cerium oxide particles is 260 nm, as measured by the laser diffraction method by a Mastersizer particle size distribution measuring device.

In Patent Document 6, crystalline cerium oxide particles have a particle size of 10 nm or less, as determined from the specific surface area measured by the gas adsorption method, and it was understood that the polishing rate drops significantly, even if the ratio of the particle size measured in liquid by the dynamic light scattering method to the particle size as determined from the specific surface area measured by the gas adsorption method is set to 14. Note that at this time, the ratio of the mean particle size (b1) measured in liquid by the laser diffraction method to the particle size (b2) as determined from the specific surface area measured by the gas adsorption method was 13.

However, the inventor of the present invention knew that in a composition for polishing in which ammonium polyacrylate with a high average molecular weight is added to an aqueous sol containing near-monodisperse cerium oxide particles, the particle size measured by the laser diffraction method is greater than 150 nm, and monodispersion of a polishing fluid is not maintained. Because the agglomerated particle size measured by the laser diffraction method is large, it is easily inferred that minute defects in a polished surface, such as shallow scratches and the like, would tend to occur. Also, if the polishing fluid is left at rest for a long period of time, the particles settle out of the fluid and form a consolidated mass, so that they are not easily re-dispersed.

The inventor of the present invention knew that crystalline cerium oxide has good dispersability, because of the relationship between the particle size (b2) as determined from the specific surface area measured by the gas adsorption method and the secondary particle size (b1) measured in liquid by the laser diffraction method. Crystalline cerium oxide would therefore yield a composition for polishing that produces a good polished surface at a high polishing rate.

It is easily inferred that if the secondary particle size measured in liquid by the laser diffraction method is large, minute defects in the polished surface, such as shallow scratches and the like, would tend to occur. Also, if the polishing fluid is left at rest for a long period of time, the particles settle out of the fluid and form a consolidated mass, so that they are not easily re-dispersed.

The present invention is a composition for polishing that prevents the occurrence of minute surface defects in the polished surface by being used for planarization polishing in a semiconductor device manufacturing process that is generally called chemical mechanical polishing (CMP). Also, if the polishing fluid is left at rest for a long period of time, the particles do not settle out of the fluid and form a consolidated mass, so they are easily re-dispersed.

Means for Solving the Problem

According to a first aspect of the present invention, the composition for polishing includes a component (A), which is a water-soluble organic compound containing a carboxyl group or a salt thereof; and a component (B), which is an aqueous sol of cerium oxide particles obtained by calcining a cerium compound by holding it in at least two different calcining temperature ranges and wet-milling the resultant cerium oxide powder until the ratio of the mean particle size (b1) measured in the aqueous sol by the laser diffraction method to the particle size (b2) as determined from the specific surface area measured by the gas adsorption method is in the range of either 1 to 4 or 15 to 40. The mean particle size measured in the composition for polishing by the laser diffraction method is 50 to 150 nm.

According to a second aspect of the present invention, the component (A) of the composition for polishing according to the first aspect is a polymer component (A-1) with an average molecular weight of 1000 to 4000 that contains ammonium acrylate and/or ammonium methacrylate.

According to a third aspect of the present invention, the component (A) of the composition for polishing according to the first aspect is a component (A-2) that is an amino acid or a derivative thereof.

According to a fourth aspect of the present invention, the component (B) of the composition for polishing according to any one of the first to third aspects is an aqueous sol of cerium oxide particles obtained by a process in which the cerium compound is calcined by holding it in two calcining temperature ranges, that is, a range of 200 to 350˚C and a range of 400 to 550˚C, and the resultant cerium oxide powder is wet-milled.

According to a fifth aspect of the present invention, the component (B) of the composition for polishing according to any one of the first to fourth aspects is an aqueous sol containing cerium oxide particles in which the mean particle size (b1) measured in the aqueous sol by the laser diffraction method is 80 to 130 nm, the particle size (b2) as determined from the specific surface area measured by the gas adsorption method is 3 to 10 nm, and the ratio of the mean particle size (b1) measured in the aqueous sol by the laser diffraction method to the particle size (b2) as determined from the specific surface area measured by the gas adsorption method is in the range of 15 to 40.

According to a sixth aspect of the present invention, the component (B) of the composition for polishing according to any one of the first to third aspects is an aqueous sol of cerium oxide particles obtained by a process in which the cerium compound is calcined by holding it in two calcining temperature ranges, that is, a range of 200 to 350˚C and a range of 700 to 850˚C, and the resultant cerium oxide powder is wet-milled.

According to a seventh aspect of the present invention, the component (B) of the composition for polishing according to any one of the first to third aspects and the sixth aspect is an aqueous sol containing cerium oxide particles in which the mean particle size (b1) measured in the aqueous sol by the laser diffraction method is 40 to 130 nm, the particle size (b2) as determined from the specific surface area measured by the gas adsorption method is 20 to 100 nm, and the ratio of the mean particle size (b1) measured in the aqueous sol by the laser diffraction method to the particle size (b2) as determined from the specific surface area measured by the gas adsorption method is in the range of 1 to 4.

According to an eighth aspect of the present invention, in the composition for polishing according to any one of the first to seventh aspects, the solids content of the component (A) constitutes 0.001 to 4.5% of the composition by weight, the solids content of the component (B) constitutes 0.001 to 1.5% of the composition by weight, and the weight ratio of the component (A) solids to the component (B) solids is 0.1 to 3.0.

According to a ninth aspect of the present invention, for the composition for polishing according to any one of the first to eighth aspects, a slurry of the cerium oxide powder in an aqueous medium is milled by a non-continuous milling apparatus using stabilized zirconia powder beads with a diameter of 0.1 to 3.0 mm, with a volumetric ratio of slurry to beads from 1:0.5 to 1:2.0.

According to a tenth aspect of the present invention, for the composition for polishing according to any one of the first to eighth aspects, the slurry of the cerium oxide powder in an aqueous medium is milled using stabilized zirconia powder beads with a diameter of 0.03 to 1 mm and a continuous milling apparatus that is configured from a mixing blade with a peripheral velocity of 1 to 3 m/sec. and a milling vessel, the milling vessel having a volume of V liters, the flow rate of the slurry through the milling vessel being from V/4 to V liters per minute, and the volumetric ratio of slurry to beads in the milling vessel being from 1:0.5 to 1:0.9.

According to an eleventh aspect of the present invention, the composition for polishing according to any one of the first to tenth aspects polishes a substrate having silica as its main component.

According to a twelfth aspect of the present invention, the composition for polishing according to any one of the first to tenth aspects polishes a semiconductor device substrate on which a silicon oxide film and a silicon nitride film are formed in a pattern.

Effects of the Invention

The present invention is the composition for polishing, which includes a component (A), which is a water-soluble organic compound containing a carboxyl group or a salt thereof; and a component (B), which is an aqueous sol of cerium oxide particles obtained by calcining a cerium compound by holding it in at least two different calcining temperature ranges and wet-milling the resultant cerium oxide powder until the ratio of the mean particle size (b1) measured in the aqueous sol by the laser diffraction method to the particle size (b2) as determined from the specific surface area measured by the gas adsorption method is in the range of either 1 to 4 or 15 to 40. The mean particle size measured in the composition for polishing by the laser diffraction method is 50 to 150 nm. The present invention is also a polishing method that uses the composition for polishing.

The component (B), the aqueous sol of cerium oxide particles, is characterized as an aqueous sol of cerium oxide that contains cerium oxide particles obtained by wet-milling the cerium oxide powder obtained by a multi-stage calcination process in which at least two passes are made through different temperature ranges in which the temperature is fixed; with almost no change in temperature. The component (B) may be an aqueous sol containing cerium oxide particles obtained by wet-milling a cerium oxide powder calcined in a combination of a comparatively low calcining temperature range and a medium calcining temperature range, and the component (B) may be an aqueous sol containing cerium oxide particles obtained by wet-milling a cerium oxide powder calcined in a combination of a comparatively low calcining temperature range and a comparatively high calcining temperature range. Both aqueous sols are used as compositions for polishing according to the present invention. When the compositions for polishing according to the present invention are used in combination with the component (A), the compositions for polishing must have a mean particle size of 50 to 150 nm, as measured in the compositions for polishing by the laser diffraction method.

The polishing characteristics of the compositions for polishing on a semiconductor substrate are such that the polishing rate for the silicon oxide film is high, the polishing rate for the silicon nitride film is low, and the ratio of the silicon oxide film polishing rate to the silicon nitride film polishing rate is high. Therefore, the silicon oxide film is polished very rapidly, and the polishing stops at the silicon nitride film portion. In a semiconductor device isolation process called shallow trench isolation, the difference in level between the silicon nitride film surface and the silicon oxide film surface is small, and a planar surface without scratches is obtained.

It has been ascertained that the two types of aqueous sols described for the component (B), which is used together with the component (A), function effectively to exhibit these polishing characteristics.

Therefore, the compositions for polishing are suitable for use as polishing agents for planarization polishing in the semiconductor device manufacturing process that is generally called chemical mechanical polishing (CMP). In particular, because polishing can be done precisely, without inflicting damage on the silicon oxide film in the trench portions or on the silicon nitride film that is used as a protective film, the compositions for polishing are suitable for use as polishing agents in the semiconductor device isolation process called shallow trench isolation (STI). The compositions for polishing are also suitable for use as polishing agents for polishing low-permittivity materials that are used as insulating films between layers in semiconductor devices, such as siloxane materials, organic polymer materials, porous materials, CVD polymer materials, and the like. Examples of siloxane materials include silsesquioxane hydride, methyl silsesquioxane, and methyl silsesquioxane hydride. Examples of organic polymer materials include polyarylene ethers, thermal polymer hydrocarbons, perfluoro-hydrocarbons, polyquinoline, and polyimide fluoride. Examples of porous materials include xerogel and silica colloid. Examples of CVD polymer materials include fluorocarbons, aromatic hydrocarbon polymers, and siloxane polymers.

The substrate having silica as its main component may be, for example, quartz, silica glass, a glass hard disk, or an organic film, low-permittivity film, insulating film between layers, or trench isolation formation in a semiconductor device, among others. Other substrates for which the compositions for polishing can be used include optical crystal materials, such as lithium niobate, lithium tantalate, and the like, ceramic materials, such as aluminum nitride, alumina, ferrite, zirconia, and the like, and metal wiring in semiconductor devices, such as aluminum, copper, tungsten, and the like.

BEST MODES FOR CARRYING OUT THE INVENTION

The main subject matter of the present invention is a composition for polishing that includes a component (A), which is a water-soluble organic compound containing a carboxyl group or a salt thereof, and a component (B), which is an aqueous sol of cerium oxide particles obtained by calcining a cerium compound by holding it in at least two different calcining temperature ranges and wet-milling the resultant cerium oxide powder until the ratio of the mean particle size (b1) measured in the aqueous sol by the laser diffraction method to the particle size (b2) as determined from the specific surface area measured by the gas adsorption method is in the range of either 1 to 4 or 15 to 40. The composition for polishing of the present invention is an aqueous composition that contains water in addition to the component (A) and the component (B).

The component (A), the water-soluble organic compound containing a carboxyl group or a salt thereof, that is used in the present invention is a polymer or low molecular weight compound containing at least one carboxyl group or salt thereof within its molecule. For example, it may a polymer component (A-1) with an average molecular weight of 1,000 to 4,000 that contains ammonium acrylate and/or ammonium methacrylate, or it may be an amino acid or amino acid derivative component (A-2).

The component (A-1) is an ammonium salt of a polymer of acrylic acid or methacrylic acid. The polymer may be a homopolymer, a copolymer of acrylic acid and methacrylic acid, or another polymeric compound and a copolymer. The other polymeric compound may be a monobasic unsaturated carboxylic acid such as sorbic acid, crotonic acid, tiglic acid, or the like, or a dibasic unsaturated carboxylic acid such as muconic acid, maleic acid, fumaric acid, citraconic acid, mesaconic acid, itaconic acid, or the like. The copolymer component may be any one of the following acrylic acid esters: 2-hydroxyethyl methacrylate, 2-hydroxypropyl methacrylate, isobutyl methacrylate, t-butyl methacrylate, isobutyl methacrylate, 2-ethylhexyl methacrylate, stearyl acrylate, 2-ethylhexyl carbitol acrylate, 2-methoxyethyl acrylate, butoxyethyl acrylate, ethoxyethoxyethyl acrylate, methoxy-triethylene glycol acrylate, methoxypolyethylene glycol acrylate, stearyl methacrylate, cyclohexyl methacrylate, tetrahydrofurfuryl methacrylate, isobonyl methacrylate, dicyclopentenyl acrylate, benzyl acrylate, phenylglycidyl ether epoxy acrylate, phenoxyethyl methacrylate, phenoxypolyethylene glycol acrylate, nonylphenol ethoxyated acrylate, acryloyloxyethyl phthalate, tribromophenyl acrylate, tribromophenol ethoxyated methacrylate, methyl methacrylate, tribromophenyl methacrylate, methacryloyl oxyethylate, methacryloyl oxyethyl maleate, methacryloyl oxyethyl phthalate, polyethylene glycol methacrylate, polypropylene glycol methacrylate, N-methyl acrylamide, N-dimethyl acrylamide, N-dimethyl aminoethyl methacrylate, N-dimethyl aminopropyl acrylamide, glycidyl methacrylate, n-butyl methacrylate, ethyl methacrylate, methacrylate alyl, cetyl methacrylate, pentadyl methacrylate, methoxypolyethylene glycol methacrylate, diethyl aminoethyl methacrylate, methacroyl oxyethyl succinate, hexanediol diacrylate, neopentyl glycol diacrylate, triethylene glycol diacrylate, polyethylene glycol diacrylate, polypropylene glycol diacrylate, hydroxypivalic acid ester neopentyl, penta-erythritol diacrylate monostearate, glycol diacrylate, 2-hydroxyethyl metaacryloyl phosphate, bis-phenol-A ethylene glycol-added acrylate, bis-phenol-F ethylene glycol-added acrylate, tricyclodecane methanol diacrylate, tris-hydroxyethyl isocyanulate diacrylate, 2-hydroxy-1-acryloxy-3-methacryloxypropane, trimethylol propane triacrylate, trimethylol propane ethylene glycol-added triacrylate, trimethylol propane propylene glycol-added triacrylate, penta-erythritol triacrylate, tris-acryloyloxyethyl phosphate, tris-hydroxyethyl isocyanulate triacrylate, denatured ε-caprolactone triacrylate, trimethylol propane ethoxy-triacrylate, glycerin propylene glycol-added tris-acrylate, penta-erythritol tetra-acrylate, penta-erythritol ethylene glycol-added tetra-acrylate, di-trimethylol propane tetra-acrylate, di-penta-erythritol hexa-penta-acrylate, di-penta-erythritol monohydroxy-penta-acrylate, urethane acrylate, epoxide acrylate, polyester acrylate, unsaturated polyester, and the like.

The mole ratio of ammonium carboxylate to carboxylic acid ester in the polymer of the component (A-1) is 100:

0 to 80:20.

Ammonium polyacrylate is the most desirable choice for the component (A-1).

It is desirable for the average molecular weight of the polymer to be in the range of 1000 to 4000. If the average molecular weight of the polymer in the composition for polishing exceeds 4000, the mean particle size measured by the laser diffraction method increases and agglomeration is seen. If the average molecular weight of the polymer in the composition for polishing is less than 1000, there is only a slight dispersing effect when the polymer is used in the composition for polishing. The component (A-1) is an ammonium salt of the polymer, but a sodium salt, potassium salt, or the like can be present at a mole ratio no greater than 20% of the ammonium salt.

Examples of the component (A-2) include aliphatic amino acids, aromatic amino acids, and heterocyclic amino acids, as well as salts thereof and amino acid surface active agents.

The aliphatic amino acids include mono-amino mono-carboxylic acids such as glycine, alanine, valine, leucine, isoleucine, and the like, oxyamino acids such as serine, threonine, and the like, amino acids that contain heteroatoms, such as cysteine, cystine, methionine, and the like, mono-amino carboxylic acids such as asparagine, glutamine, and the like, and di-amino mono-carboxylic acids such as lysine, arginine, and the like.

The aromatic amino acids include phenylalanine, tyrosine, and the like.

The heterocyclic amino acids include histidine, tryptophan, proline, oxyproline, and the like.

These amino acids, as well as salts thereof, including ammonium salts, sodium salts, potassium salts, and the like, are used. It is preferable for the amino acids and their salts to be used in a molecular weight range of 70 to 500.

Examples of amino acid surface active agents include N-substituted amino acids and salts thereof, such as N-acyl amino acid and salts thereof. The salts may be sodium salts or potassium salts formed from NaOH or KOH, respectively, or salts formed from triethanolamine or ammonia. Examples include coconut oil fatty acid sarcosine triethanolamine, coconut oil fatty acid acylalanine triethanolamine, coconut oil fatty acid glutamate triethanolamine, lauric acid glutamate triethanolamine.

It is preferable for these amino acid surface active agents to have a molecular weight of 1,000 to 10,000.

It is preferable for the solids content of the component (A) in the composition for polishing to be in the range of 0.001 to 4.5% by weight.

The component (B) that is used in the present invention is an aqueous sol of cerium oxide particles obtained by calcining a cerium compound by holding it in at least two different calcining temperature ranges and wet-milling the resultant cerium oxide powder until the ratio of the mean particle size (b1) measured in the aqueous sol by the laser diffraction method to the particle size (b2) as determined from the specific surface area measured by the gas adsorption method is in the range of either 1 to 4 or 15 to 40.

Any cerium compound that is converted into cerium oxide by calcining can be used. Examples include cerium carbonate, cerium oxycarbonate, ammonium cerium carbonate, cerium chloride, cerium oxychloride, ammonium cerium chloride, cerium nitrate, cerium oxynitrate, ammonium cerium nitrate, cerium sulfate, cerium oxysulfate, ammonium cerium sulfate, cerium acetate, cerium oxalate, and the like. Of these, cerium carbonate is preferable.

With regard to the calcining temperature ranges, calcining is done while maintaining a fixed temperature with almost no change in temperature, so as a rough standard, it is necessary to limit the temperature change to no more than 20˚C per hour, for example. Calcining is done by making at least two passes through the calcining temperature ranges. Desirable methods include calcining by passing through a calcining temperature range of 200 to 350˚C and then passing through a calcining temperature range of 400 to 550˚C (a first calcining method) and calcining by passing through a calcining temperature range of 200 to 350˚C and then passing through a calcining temperature range of 700 to 850˚C (a second calcining method).

The calcining time in each calcining temperature range is generally from 2 hours to 60 hours, but the time is set to fit the amount of cerium oxide that is calcined.

The holding time in the later calcining temperature range is two to six times the holding time in the earlier calcining temperature range. Normally, the earlier calcining temperature range is maintained for 2 to 10 hours, so the later calcining temperature range is maintained for 4 to 60 hours.

In the first calcining method, the initial calcining at 200 to 350˚C is a process for converting the raw material cerium compound, for example, cerium carbonate, into cerium oxide or a cerium oxide precursor, such as by using calcining to eliminate components other than cerium from the cerium carbonate, for example. Carrying out this calcining at a fixed temperature makes it possible to obtain cerium oxide with a uniform primary particle size at the primary particle stage.

Next, calcining is continued at 400 to 550˚C. Calcining in the 400 to 550˚C calcining temperature range produces a cerium oxide powder with high surface activity and comparatively low crystallinity. The cerium oxide powder is then wet-milled to produce cerium oxide particles, but the value of the particle size of the cerium oxide particles, as determined from the specific surface area measured by the gas adsorption method, is small. Also, because the surface activity of the particles is high, the particles have a strong tendency to agglomerate in an aqueous medium, so that the mean particle size measured in an aqueous sol by the laser diffraction method is large. Therefore, the ratio of the mean particle size (b1) measured in the aqueous sol by the laser diffraction method to the particle size (b2) as determined from the specific surface area measured by the gas adsorption method is high. Therefore, when these particles are used in the composition for polishing, the agglomerations of particles easily break up on the polished surface, dividing into particles that are close to the primary particle size. New abrasive particle surfaces thereby appear, and polishing is facilitated by the chemical action of these surfaces.

The aqueous sol of cerium oxide particles obtained by wet-milling of the cerium oxide powder produced by the first calcining method is an aqueous sol containing cerium oxide particles for which the mean particle size (b1) measured in the sol by the laser diffraction method is 80 to 130 nm, the particle size (b2) as determined from the specific surface area measured by the gas adsorption method is 3 to 10 nm, and the ratio of the mean particle size (b1) measured in the aqueous sol by the laser diffraction method to the particle size (b2) as determined from the specific surface area measured by the gas adsorption method is in the range of 15 to 40. Particles with a size of 1 $\mu$m or greater are not present in the sol.

In the second calcining method, the initial calcining at 200 to 350°C is a process for converting the raw material cerium compound, for example, cerium carbonate, into cerium oxide or a cerium oxide precursor, such as by using calcining to eliminate components other than cerium from the cerium carbonate, for example. Carrying out this calcining at a fixed temperature makes it possible to obtain cerium oxide with a uniform primary particle size at the primary particle stage.

Next, calcining is continued at 700 to 850°C. Calcining in the 700 to 850°C calcining temperature range produces a cerium oxide powder with low surface activity and high crystallinity. The cerium oxide powder is then wet-milled to produce cerium oxide particles, but the value of the particle size of the cerium oxide particles, as determined from the specific surface area measured by the gas adsorption method, is large. Also, because the surface activity of the particles is low, the particles have only a slight tendency to agglomerate in an aqueous medium, so that the mean particle size measured in an aqueous sol by the laser diffraction method is small. Therefore, the ratio of the mean particle size (b1) measured in the aqueous sol by the laser diffraction method to the particle size (b2) as determined from the specific surface area measured by the gas adsorption method is low. Therefore, when these particles are used in the composition for polishing, the polishing rate on the polished surface is proportionate to the degree of crystallinity. Moreover, the brittleness of the highly crystalline particles means that the particles tend to crack on the polished surface. New abrasive particle surfaces thereby appear, and polishing is facilitated by the chemical action of these surfaces.

The aqueous sol of cerium oxide particles obtained by wet-milling of the cerium oxide powder produced by the second calcining method is an aqueous sol containing cerium oxide particles for which the mean particle size (b1) measured in the sol by the laser diffraction method is 40 to 130 nm, the particle size (b2) as determined from the specific surface area measured by the gas adsorption method is 20 to 100 nm, and the ratio of the mean particle size (b1) measured in the aqueous sol by the laser diffraction method to the particle size (b2) as determined from the specific surface area measured by the gas adsorption method is in the range of 1 to 4.

A slurry containing the cerium oxide powder obtained by either the first calcining method or the second calcining method is wet-milled to produce the aqueous sol of cerium oxide particles.

For the wet milling, either a method that uses a non-continuous milling apparatus (batch apparatus), such as a ball mill apparatus, a sand grinder apparatus, an attritor apparatus, or the like, or a method that uses a continuous milling apparatus can be selected.

If the wet milling is carried out by a non-continuous milling apparatus, a slurry of cerium oxide powder in an aqueous medium is milled by the non-continuous milling apparatus using stabilized zirconia powder beads with a diameter of 0.1 to 3.0 mm, with a volumetric ratio of slurry to beads from 1:0.5 to 1:2.0. For example, if a ball mill is used, milling is carried out for a period of 8 to 72 hours (preferably 8 to 48 hours) at a revolution speed of 30 to 100 rpm.

If the wet milling is carried out by a continuous milling apparatus, a slurry of cerium oxide powder in an aqueous medium is milled by the continuous milling apparatus, which is configured from a mixing blade with a peripheral velocity of 1 to 3 m/sec. and a milling vessel, using stabilized zirconia powder beads with a diameter of 0.03 to 3 mm (preferably 0.1 to 1 mm). Assuming a volume of V liters for the milling vessel, the flow rate of the slurry through the milling vessel is from V/4 to V liters per minute, and the volumetric ratio of slurry to beads in the milling vessel is from 1:0.5 to 1:0.9. In the continuous milling apparatus, the cerium oxide powder to be milled passes through the milling vessel 80 to 200 times (preferably 80 to 160 times).

When the cerium oxide powder is wet-milled, it is preferable to wet-mill an aqueous slurry to which has been added an acid (such as nitric acid, hydrochloric acid, acetic acid, or the like), a water-soluble macromolecule (such as an acrylate polymer or an ammonium salt thereof, a methacrylate polymer or an ammonium salt thereof, or the like), an anionic surface active agent, a cationic surface active agent, or a nonionic surface active agent (such as ammonium oleate, ammonium lauryl sulfate, triethanolamine lauryl sulfate, ammonium polyoxyethylene lauryl ether sulfate, or the like), a water-soluble alkali silicate with a water-soluble alkali source (such as a quaternary ammonium halide or quaternary ammonium hydroxide or a mixture thereof, lithium hydroxide, sodium hydroxide, potassium hydroxide, aqueous ammonia, or the like), and a water-soluble dispersing agent (such as ammonium salts (such as quaternary ammonium hydroxide, ammonium hexametaphosphate, ammonium polyacrylate, or the like), sodium salts (such as sodium hexametaphosphate, sodium polyacrylate; or the like), or the like).

During wet milling, it is desirable for the concentration of solids in the aqueous slurry to be 10 to 70% by weight, and even more desirable for it to be 30 to 60% by weight. If the concentration of solids is lower than 10%, the milling efficiency becomes poor. On the other hand, if the concentration of solids is higher than 70%, the viscosity of the aqueous slurry increases and milling becomes impossible.

When the aqueous sol of the cerium oxide particles is dried, the cerium oxide particle size as determined from the specific surface area measured by the gas adsorption method (BET method) is measured as the mean value of the diameters of individual particles.

When the particle size is measured by the laser diffraction method, it is measured by an apparatus such as a Mastersizer (made by Malvern Instruments), or the like. The laser diffraction method measures the sizes of the particles in the sol, and when agglomerations and adhesions are present, the sizes of those particles are measured. The dynamic light scattering method also measures the sizes of the particles in the sol, and when agglomerations and adhesions are present, the sizes of those particles are measured. Dynamic light scattering method measurements are made using a DLS6000 (Otsuka Electronics Co., Ltd.) or the like.

Cerium oxide particles obtained by the present invention are crystalline cerium oxide particles with a primary particle size of 3 to 100 nm as measured by a transmission electron microscope (TEM). When the cerium oxide particles are dried at 110°C and their X-ray diffraction pattern is measured, the cerium oxide particles have their main peaks at diffraction angles $2\theta = 28.6°$, $47.5°$, and $56.4°$ and exhibit the high cubic crystallinity described in ASTM Card No. 34-394. The particle size (b2), which is determined by using the gas adsorption method (BET method) to measure the specific surface area and then converting the result into the particle size of spherical particles, is called the BET method converted particle size. According to the Schuller method, the size of the X-ray crystallites is 4 to 15 nm for the cerium oxide particles obtained by the first calcining method and 30 to 150 nm for the cerium oxide particles obtained by the second calcining method. Here, the size of the X-ray crystallites according to the Schuller method is determined by the formula below.

$$\text{X-ray crystallite size (Å)} = 0.9\lambda \, / \, \beta\cos\theta$$

$\lambda$ is the wavelength (Å) of the tube of the X-ray diffraction apparatus used for measurement. Here, a copper tube is used, so $\lambda = 1.542$ Å.

$\beta$ is the measured half-width (in radians) of the peak at the diffraction angle $2\theta = 28.6°$.

$\theta$ is the measured peak position $2\theta = 28.6°$, converted to radians.

In the composition for polishing, it is preferable for the solids content of the component (A) to constitute 0.001 to 4.5% of the composition by weight, for the solids content of the component (B) to constitute 0.001 to 1.5% of the composition by weight, and for the weight ratio of the component (A) solids to the component (B) solids to be 0.1 to 3.0.

Component (B), the aqueous sol of cerium oxide particles, is obtained by wet-milling, in the form of an aqueous slurry, the cerium oxide powder obtained by either the first calcining method or the second calcining method. The composition for polishing is obtained by mixing the component (B) with the component (A). The mean particle size of the particles in the composition for polishing is 50 to 150 nm, as measured by the laser diffraction method.

Even if the composition for polishing of the present invention is left at rest for a long period of time, the particles exhibit little tendency to settle out and form a consolidated mass, so by light stirring or shaking, they can easily be restored to their state of dispersion at the time of manufacture, and the composition remains stable for six months or longer even if stored at room temperature.

Examples

Example 1 (component (B) manufactured using the first calcining method)

1.2 kg of commercially available, 99.9% pure cerium carbonate powder (with a mean particle size of 22 $\mu$m, as measured in an aqueous slurry by the laser diffraction method) was calcined for 5 hours at 350°C in an electric furnace with a capacity of 72 liters, after which the temperature was raised to 400°C and the powder was calcined for 20 hours at 400°C, yielding 0.6 kg of calcined powder. When this powder was measured by an X-ray diffraction apparatus, the main peaks were at diffraction angles $2\theta = 28.6°$, $47.5°$, and $56.4°$, matching the characteristics of cubic crystalline cerium oxide described in ASTM Card No. 34-394. The specific surface area of the cerium oxide particles, as measured by the gas adsorption method (BET method), was 144 $m^2/g$, and the particle size, as determined from the specific surface area measured by the gas adsorption method, was 5.8 nm.

A slurry containing a mixture of 380 g of the obtained cerium oxide powder, 42 g of 35% ammonium polyacrylate (average molecular weight: 1400) as a dispersing agent during milling, and 683 g of purified water was placed in a 3-liter ball mill vessel along with 3800 g of zirconia beads 1 mm in diameter and milled for 13 hours at 60 rpm. This produced a mean particle size of 136 nm, as measured by the laser diffraction method using a Mastersizer 2000 (made by Marvern), and the ratio of particles with a diameter of 1 $\mu$m or greater was 2.3%. The beads were separated out using purified water, yielding 1862 g of aqueous sol with a solids content of 20.0% by weight. The resulting cerium oxide particles had a specific surface area of 146 m$^2$/g, as measured by the gas adsorption method (BET method), with a particle size of 5.7 nm, as determined from the specific surface area measured by the gas adsorption method. Coarse particles were removed by classifying 1730 g of the aqueous sol by the static method, yielding 1600 g of an aqueous sol (1), in which the cerium oxide particles had a specific surface area of 149 m$^2$/g, as measured by the gas adsorption method (BET method), with a particle size of 5.6 nm, as determined from the specific surface area measured by the gas adsorption method. The mean particle size measured by the laser diffraction method was 121 nm, and no particles with a diameter of 1 $\mu$m or greater were present. The aqueous sol had a pH of 10.2, an electrical conductivity of 1060 $\mu$S/cm, a solids content of 19.4% by weight, and a recovery rate of 90% for the cerium oxide particles. The mean particle size measured by the dynamic light scattering method using a DLS6000 (Otsuka Electronics Co., Ltd.) was 245 nm, and the mean value of the primary particle size measured by a transmission electron microscope (TEM) was 3 nm, and the X-ray crystallite size measured by the Schuller formula was 11 nm. The ratio of the mean particle size measured in the aqueous sol by the laser diffraction method to the particle size as determined from the specific surface area measured by the gas adsorption method was 22.

Example 2 (component (B) manufactured using the first calcining method)

A slurry containing a mixture of 380 g of the cerium oxide powder obtained in Example 1, 33 g of 35% ammonium polyacrylate (average molecular weight: 1400) as a dispersing agent during milling, and 687 g of purified water was placed in a 3-liter ball mill vessel along with 3800 g of zirconia beads 1 mm in diameter and milled for 9 hours and 10 minutes at 60 rpm. This produced a mean particle size of 166 nm, as measured by the laser diffraction method using the Mastersizer 2000 (made by Marvern), and the ratio of particles with a diameter of 1 $\mu$m or greater was 5.1 %. The beads were separated out using purified water, yielding 1838 g of aqueous sol with a solids content of 20.0% by weight. The resulting cerium oxide particles had a specific surface area of 146 m$^2$/g, as measured by the gas adsorption method (BET method), with a particle size of 5.7 nm, as determined from the specific surface area measured by the gas adsorption method. Coarse particles were removed by classifying 1730 g of the aqueous sol by the static method, yielding 1209 g of an aqueous sol (2), in which the cerium oxide particles had a specific surface area of 147 m$^2$/g, as measured by the gas adsorption method (BET method), with a particle size of 5.7 nm, as determined from the specific surface area measured by the gas adsorption method. The mean particle size measured by the laser diffraction method was 122 nm, and no particles with a diameter of 1 $\mu$m or greater were present. The aqueous sol had a pH of 10.2, an electrical conductivity of 990 $\mu$S/cm, a viscosity of 1.3 mPa·s, a solids content of 16.1% by weight, and a recovery rate of 70% for the cerium oxide particles. The mean value of the primary particle size measured by a transmission electron microscope (TEM) was 3 nm, and the X-ray crystallite size measured by the Schuller formula was 11 nm. The ratio of the mean particle size measured in the aqueous sol by the laser diffraction method to the particle size as determined from the specific surface area measured by the gas adsorption method was 21.

Example 3 (component (B) manufactured using the first calcining method)

1.2 kg of commercially available, 99.9% pure cerium carbonate powder (with a mean particle size of 22 $\mu$m, as measured in an aqueous slurry by the laser diffraction method) was calcined for 5 hours at 350˚C in an electric furnace with a capacity of 72 liters, after which the temperature was raised to 550˚C and the powder was calcined for 20 hours at 550˚C, yielding 0.6 kg of calcined powder. When this powder was measured by an X-ray diffraction apparatus, the main peaks were at diffraction angles 2θ = 28.6˚, 47.5˚, and 56.4˚, matching the characteristics of cubic crystalline cerium oxide described in ASTM Card No. 34-394. The specific surface area of the cerium oxide particles, as measured by the gas adsorption method (BET method), was 104 m$^2$/g, and the particle size, as determined from the specific surface area measured by the gas adsorption method, was 8.0 nm.

A slurry containing a mixture of 380 g of the obtained cerium oxide powder, 35 g of 35% ammonium polyacrylate (average molecular weight: 1400) as a dispersing agent during milling, and 688 g of purified water was placed in a 3-liter ball mill vessel along with 3800 g of zirconia beads 1 mm in diameter and milled for 13 hours at 60 rpm. This produced a mean particle size of 138 nm, as measured by the laser diffraction method using a Mastersizer 2000 (made by Marvern), and the ratio of particles with a diameter of 1 $\mu$m or greater was 2.4%. The beads were separated out using purified water, yielding 1870 g of aqueous sol with a solids content of 20.0% by weight. The resulting cerium oxide particles had a specific surface area of 105 m$^2$/g, as measured by the gas adsorption method (BET method), with a particle size of 7.9 nm, as determined from the specific surface area measured by the gas adsorption method. Coarse particles were removed by classifying 1730 g of the aqueous sol by the static method, yielding 1577 g of an aqueous sol (3), in which the cerium oxide particles had a specific surface area of 106 m$^2$/g, as measured by the gas adsorption method (BET method), with a particle size of 7.9 nm, as determined from the specific surface area measured by the gas adsorption method. The mean particle size measured by the laser diffraction method was 122 nm, and no particles with a diameter of 1 $\mu$m or greater were present. The aqueous sol had a pH of 10.2, an electrical conductivity of 1010 $\mu$S/cm, a solids content of 19.2% by weight, and a recovery rate of 89% for the cerium oxide particles. The mean particle size measured by the dynamic light scattering method using a DLS6000 (Otsuka Electronics Co., Ltd.) was 222 nm, and the mean value of the primary particle size measured by a transmission electron microscope (TEM) was 5 nm, and the X-ray crystallite size measured by the Schuller formula was 15 nm. The ratio of the mean particle size measured in the aqueous sol by the laser diffraction method to the particle size as determined from the specific surface area measured by the gas adsorption method was 15.

Example 4 (component (B) manufactured using the first calcining method)

60 kg of commercially available, 99.9% pure cerium carbonate powder (with a mean particle size of 22 $\mu$m, as measured in an aqueous slurry by the laser diffraction method) was calcined for 5 hours at 350˚C in an electric furnace with a capacity of 0.5 m$^3$, after which the temperature was raised to 450˚C and the powder was calcined for 20 hours at 450˚C, yielding 28 kg of calcined powder. When this powder was measured by an X-ray diffraction apparatus, the main peaks were at diffraction angles 2θ = 28.6˚, 47.5˚, and 56.4˚, matching the characteristics of cubic crystalline cerium oxide described in ASTM Card No. 34-394. The specific surface area of the cerium oxide particles, as measured by the gas adsorption method (BET method), was 157 m$^2$/g, and the particle size, as determined from the specific surface area measured by the gas adsorption method, was 5.3 nm.

A slurry was created containing a mixture of 11.19 kg of the obtained cerium oxide powder, 1.23 kg of 35% ammonium polyacrylate (average molecular weight: 1400) as a dispersing agent during milling, and 21.44 kg of purified water. The slurry was milled by passing it through a continuous milling machine (an Ashizawa RL 12.5, with a mixing blade that turns at a peripheral velocity of 2.0 m/sec.), along with 26.46 kg of zirconia beads 0.5 mm in diameter, at a supply rate of 6.09 liters per minute. Passing the slurry through the milling machine 141 times produced a mean particle size of 135 nm, as measured by the laser diffraction method using a Mastersizer 2000 (made by Marvern), and the ratio of particles with a diameter of 1 $\mu$m or greater was 1.8%. The beads were separated out using purified water, yielding 54.7 kg of aqueous sol with a pH of 9.9, an electrical conductivity of 1390 $\mu$S/cm, a viscosity of 1.4 mPa·s, and a solids content of 20.0% by weight. The resulting cerium oxide particles had a specific surface area of 160 m$^2$/g, as measured by the gas adsorption method (BET method), with a particle size of 5.2 nm, as determined from the specific surface area measured by the gas adsorption method. Coarse particles were removed by classifying 25.9 kg of the aqueous sol by the static method, yielding 21.47 kg of an aqueous sol (4), in which the cerium oxide particles had a specific surface area of 147 m$^2$/g, as measured by the gas adsorption method (BET method), with a particle size of 5.5 nm, as determined from the specific surface area measured by the gas adsorption method. The mean particle size measured by the laser diffraction method was 126 nm, and no particles with a diameter of 1 $\mu$m or greater were present. The aqueous sol had a pH of 9.8, an electrical conductivity of 1650 $\mu$S/cm, a viscosity of 1.2 mPa·s, a solids content of 18.4% by weight, and a recovery rate of 76% for the cerium oxide particles. The mean particle size measured by the dynamic light scattering method using a DLS6000 (Otsuka Electronics Co., Ltd.) was 245 nm. The ratio of the mean particle size measured in the aqueous sol by the laser diffraction method to the particle size as determined from the specific surface area measured by the gas adsorption method was 23.

Next, coarse particles were removed once more by classifying 1056 g of the aqueous sol (4) by the static method, yielding 915 g of the aqueous sol (4), in which the cerium oxide particles had a specific surface area of 157 m$^2$/g, as measured by the gas adsorption method (BET method), with a particle size of 5.3 nm, as determined from the specific surface area measured by the gas adsorption method. The mean particle size measured by the laser diffraction method was 106 nm, and no particles with a diameter of 0.5 $\mu$m or greater or particles with a diameter of 1 $\mu$m or greater were present. The aqueous sol had a pH of 9.9, an electrical conductivity of 1620 $\mu$S/cm, a viscosity of 1.1 mPa·s, a solids content of 10.3% by weight, and a recovery rate of 50% for the cerium oxide particles. The mean particle size measured by the dynamic light scattering method using a DLS6000 (Otsuka Electronics Co., Ltd.) was 197 nm. The ratio of the mean particle size measured in the aqueous sol by the laser diffraction method to the particle size as determined from the specific surface area measured by the gas adsorption method was 20.

Example 5 (component (B) manufactured using the second calcining method)

60 kg of commercially available, 99.9% pure cerium carbonate powder (with a mean particle size of 38 $\mu$m,

as measured in an aqueous slurry by the laser diffraction method) was calcined for 5 hours at 350˚C, after which the temperature was raised to 755˚C and the powder was calcined for 15 hours at 755˚C, yielding 30 kg of calcined powder with a primary particle size of 30 to 50 nm as measured by a scanning electron microscope (SEM). When this powder was measured by an X-ray diffraction apparatus, the main peaks were at diffraction angles $2\theta = 28.6°$, $47.5°$, and $56.4°$, matching the characteristics of cubic crystalline cerium oxide described in ASTM Card No. 34-394. The specific surface area of the cerium oxide particles, as measured by the gas adsorption method (BET method), was 15.2 m$^2$/g, and the particle size, as determined from the specific surface area measured by the gas adsorption method, was 55 nm.

A slurry was created by adding 14 kg of the obtained cerium oxide (IV) powder to an aqueous solution containing 800 g of 35% ammonium polyacrylate (average molecular weight: 1400) as a dispersing agent during milling and 27.6 kg of purified water. The slurry was milled by passing it through a continuous milling machine (an Ashizawa RL12.5, with a mixing blade that turns at a peripheral velocity of 2.0 m/sec.), along with 26.46 kg of zirconia beads 0.5 mm in diameter, at a supply rate of 6.09 liters per minute. Passing the slurry through the milling machine 105 times produced a mean particle size of 143 nm, as measured by the laser diffraction method using a Mastersizer 2000 (made by Marvern). The beads were separated out using purified water, yielding 59.4 kg of aqueous sol with a pH of 9.0, an electrical conductivity of 2880 $\mu$S/cm, a viscosity of 1.4 mPa·s, and a solids content of 25.8% by weight. The resulting cerium oxide (IV) particles had a specific surface area of 23.7 m$^2$/g, as measured by the gas adsorption method (BET method), with a particle size of 35 nm, as determined from the specific surface area measured by the gas adsorption method. After the aqueous sol was modified with purified water to 25.9 kg of an aqueous sol with a solids content of 20% by weight, coarse particles were removed by the static method, yielding 22.2 kg of an aqueous sol (5) with a pH of 8.9, an electrical conductivity of 2230 $\mu$S/cm, a viscosity of 1.3 mPa·s, and a solids content of 16.1% by weight. The obtained cerium oxide (IV) particles had a specific surface area of 25.6 m$^2$/g, as measured by the gas adsorption method (BET method), with a particle size (b2) of 33 nm, as determined from the specific surface area measured by the gas adsorption method. The mean particle size (b1) measured by the laser diffraction method was 116 nm, and no particles with a diameter of 1 $\mu$m or greater were present. The mean particle size measured by the dynamic light scattering method using a DLS6000 (Otsuka Electronics Co., Ltd.) was 220 nm. The ratio of the mean particle size measured in the aqueous sol by the laser diffraction method to the particle size as determined from the specific surface area measured by the gas adsorption method was 3.5.

Example 6 (component (B) manufactured using the second calcining method)

A slurry was created by adding 14 kg of the obtained cerium oxide (IV) powder to an aqueous solution containing 287 g of 10% nitric acid as a dispersing agent during milling and 28.1 kg of purified water. The slurry was milled by passing it through a continuous milling machine (an Ashizawa RL12.5, with a mixing blade that turns at a peripheral velocity of 2.0 m/sec.), along with 26.46 kg of zirconia beads 0.5 mm in diameter, at a supply rate of 6.09 liters per minute. Passing the slurry through the milling machine 95 times produced a mean particle size of 147 nm, as measured by the laser diffraction method using a Mastersizer 2000 (made by Marvern). The beads were separated out using purified water, yielding 53.2 kg of aqueous sol with a pH of 5.3, an electrical conductivity of 42 $\mu$S/cm, a viscosity of 1.9 mPa·s, and a solids content of 26.2% by weight. The resulting cerium oxide (IV) particles had a specific surface area of 24.3 m$^2$/g, as measured by the gas adsorption method (BET method), with a particle size of 34 nm, as determined from the specific surface area measured by the gas adsorption method. After the aqueous sol was modified with purified water to 25.9 kg of an aqueous sol with a solids content of 20% by weight, coarse particles were removed by the static method, yielding 20.8 kg of an aqueous sol (6) with a pH of 5.0, an electrical conductivity of 30 $\mu$S/cm, a viscosity of 1.6 mPa·s, and a solids content of 16.4% by weight. The obtained cerium oxide (IV) particles had a specific surface area of 26.1 m$^2$/g, as measured by the gas adsorption method (BET method), with a particle size (b2) of 32 nm, as determined from the specific surface area measured by the gas adsorption method. The mean particle size (b1) measured by the laser diffraction method was 117 nm, and no particles with a diameter of 1 $\mu$m or greater were present. The mean particle size measured by the dynamic light scattering method was 203 nm. The ratio of the mean particle size measured in the aqueous sol by the laser diffraction method to the particle size as determined from the specific surface area measured by the gas adsorption method was 3.7.

Example 7 (component (B) manufactured using the second calcining method)

60 kg of commercially available, 99.9% pure cerium carbonate powder (with a mean particle size of 38 $\mu$m, as measured in an aqueous slurry by the laser diffraction method) was calcined for 5 hours at 350˚C, after which the temperature was raised to 840˚C and the powder was calcined for 15 hours at 840˚C, yielding 30 kg of calcined powder with a primary particle size of 100 to 200 nm as measured by a scanning electron microscope (SEM). When this powder was measured by an X-ray diffraction apparatus, the main peaks were at diffraction angles $2\theta = 28.6°$, $47.5°$, and $56.4°$, matching the characteristics of cubic crystalline cerium oxide described in ASTM Card No. 34-394. The specific surface area of the cerium oxide particles, as measured by the gas adsorption method (BET method), was 4.5 m$^2$/g, and the particle size, as determined from the specific surface area measured by the gas adsorption method, was 183 nm.

A slurry was created by adding 14 kg of cerium oxide powder obtained by the same operation as in Example 1 to an aqueous solution containing 212 g of 10% nitric acid as a dispersing agent during milling and 28.2 kg of purified water. The slurry was milled by passing it through a continuous milling machine (an Ashizawa RL 12.5, with a mixing blade that turns at a peripheral velocity of 2.0 m/sec.), along with 26.46 kg of zirconia beads 0.5 mm in diameter, at a supply rate of 6.09 liters per minute. Passing the slurry through the milling machine 95 times produced a mean particle size of 140 nm, as measured by the laser diffraction method using a Mastersizer 2000 (made by Marvern). The beads were separated out using purified water, yielding 54.4 kg of aqueous sol with a pH of 4.7, an electrical conductivity of 99 μS/cm, a viscosity of 1.4 mPa·s, and a solids content of 22% by weight. The resulting cerium oxide (IV) particles had a specific surface area of 11.8 m$^2$/g, as measured by the gas adsorption method (BET method), with a particle size of 71 nm, as determined from the specific surface area measured by the gas adsorption method. After the aqueous sol was modified with purified water to 25.9 kg of an aqueous sol with a solids content of 20% by weight, coarse particles were removed by the static method, yielding 21.3 kg of an aqueous sol (7) with a pH of 4.5, an electrical conductivity of 90 μS/cm, a viscosity of 1.2 mPa·s, and a solids content of 16.6% by weight. The obtained cerium oxide particles had a specific surface area of 12.7 m$^2$/g, as measured by the gas adsorption method (BET method), with a particle size (b2) of 66 nm, as determined from the specific surface area measured by the gas adsorption method. The mean particle size (b1) measured by the laser diffraction method was 128nm, and no particles with a diameter of 1 μm or greater were present. The mean particle size measured by the dynamic light scattering method was 217 nm. The ratio of the mean particle size measured in the aqueous sol by the laser diffraction method to the particle size as determined from the specific surface area measured by the gas adsorption method was 2.0.

Comparative Example 1

A slurry containing a mixture of 380 g of the cerium oxide powder obtained in Example 1, 38 g of 35% ammonium polyacrylate (average molecular weight: 1400) as a dispersing agent during milling, and 688 g of purified water was placed in a 3-liter ball mill vessel along with 3800 g of zirconia beads 1 mm in diameter and milled for 5 hours and 30 minutes at 60 rpm. This produced a mean particle size of 280 nm, as measured by the laser diffraction method using the Mastersizer 2000 (made by Marvern), and the ratio of particles with a diameter of 1 μm or greater was 10.0%. The beads were separated out using purified water, yielding 1870 g of an aqueous sol (8) with a solids content of 20.0% by weight, a pH of 10.1, and an electrical conductivity of 1290 μS/cm. The resulting cerium oxide particles had a specific surface area of 143 m$^2$/g, as measured by the gas adsorption method (BET method), with a particle size of 5.8 nm, as determined from the specific surface area measured by the gas adsorption method. The mean value of the primary particle size measured by a transmission electron microscope (TEM) was 3 nm, and the X-ray crystallite size measured by the Schuller formula was 11 nm. The ratio of the mean particle size measured in the aqueous sol by the laser diffraction method to the particle size as determined from the specific surface area measured by the gas adsorption method was 48. Coarse particles were removed by classifying 1000 g of the aqueous sol (8) by the static method, creating the aqueous sol (8), in which the cerium oxide particles had a specific surface area of 146 m$^2$/g, as measured by the gas adsorption method (BET method), with a particle size of 5.4 nm, as determined from the specific surface area measured by the gas adsorption method. The mean particle size measured by the laser diffraction method was 113 nm, and no particles with a diameter of 1 μm or greater were present. However, the recovery rate for the cerium oxide particles was only 38%.

Comparative Example 2

1.2 kg of commercially available, 99.9% pure cerium carbonate powder (with a mean particle size of 22 μm, as measured in an aqueous slurry by the laser diffraction method) was calcined for 5 hours at 350°C in an electric furnace, after which the temperature was raised to 650°C and the powder was calcined for 20 hours at 650°C, yielding 0.6 kg of calcined powder. When this powder was measured by an X-ray diffraction apparatus, the main peaks were at diffraction angles $2\theta = 28.6°$, $47.5°$, and $56.4°$, matching the characteristics of cubic crystalline cerium oxide described in ASTM Card No. 34-394. The specific surface area of the cerium oxide particles, as measured by the gas adsorption method (BET method), was 42 m$^2$/g, and the particle size, as determined from the specific surface area measured by the gas adsorption method, was 20.0 nm.

A slurry containing a mixture of 380 g of the obtained cerium oxide powder, 22 g of 35% ammonium polyacrylate (average molecular weight: 1400) as a dispersing agent during milling, and 698 g of purified water was placed in a 3-liter ball mill vessel along with 3800 g of zirconia beads 1 mm in diameter and milled for 9 hours and 20 minutes at 60 rpm. This produced a mean particle size of 167 nm, as measured by the laser diffraction method using a Mastersizer 2000 (made by Marvern), and the ratio of particles with a diameter of 1 μm or greater was 5.4%. The beads were separated out using purified water, yielding 1869 g of aqueous sol with a solids content of 20.0% by weight. The resulting cerium oxide particles had a specific surface area of 52 m$^2$/g, as measured by the gas adsorption method (BET method), with a particle size of 15.9 nm, as determined from the specific surface area measured by the gas adsorption method. Coarse particles were removed by classifying 1730 g of the aqueous sol by the static method, yielding 1010 g of an aqueous sol (9), in which the cerium oxide particles had a specific surface area of 52 m$^2$/g, as measured by the gas adsorption method (BET method), with a particle size of 15.9 nm, as determined from the specific surface area measured by the gas adsorption method. The mean particle size measured by the laser diffraction method was 115 nm, and no particles with a diameter of 1 $\mu$m or greater were present. The aqueous sol had a pH of 9.9, an electrical conductivity of 860 $\mu$S/cm, a viscosity of 1.2 mPa·s, a solids content of 15.7% by weight, and a recovery rate of 50% for the cerium oxide particles. The mean value of the primary particle size measured by a transmission electron microscope (TEM) was 15 nm, and the X-ray crystallite size measured by the Schuller formula was 23 nm. The ratio of the mean particle size measured in the aqueous sol by the laser diffraction method to the particle size as determined from the specific surface area measured by the gas adsorption method was 7.

Comparative Example 3

A slurry containing a mixture of 63 g of the cerium oxide powder obtained in Example 3, 14 g of 35% ammonium polyacrylate (average molecular weight: 1400) as a dispersing agent during milling, and 113 g of purified water was placed in a 0.5-liter ball mill vessel along with 633 g of zirconia beads 1 mm in diameter and milled for 120 hours at 60 rpm. This produced a mean particle size of 92 nm, as measured by the laser diffraction method using a Mastersizer 2000 (made by Marvern), and no particles with a diameter of 0.5 $\mu$m or greater were present. The beads were separated out using purified water, yielding 350 g of an aqueous sol (10) with a pH of 9.9, an electrical conductivity of 3900 $\mu$S/cm, and a solids content of 18.0% by weight. The resulting cerium oxide particles had a specific surface area of 119 m$^2$/g, as measured by the gas adsorption method (BET method), with a particle size of 7.0 nm, as determined from the specific surface area measured by the gas adsorption method. The mean particle size measured by the dynamic light scattering method using a DLS6000 (Otsuka Electronics Co., Ltd.) was 98 nm. Therefore, the ratio of the mean particle size measured in the aqueous sol by the dynamic light scattering method to the particle size as determined from the specific surface area measured by the gas adsorption method was 14.0. The ratio of the mean particle size measured in the aqueous sol by the laser diffraction method to the particle size as determined from the specific surface area measured by the gas adsorption method was 13.

Comparative Example 4

A slurry was created by adding 14 kg of the cerium oxide powder obtained by the same operation as in Example 6 to an aqueous solution containing 800 g of 35% ammonium polyacrylate (average molecular weight: 1400) as a dispersing agent during milling and 27.6 kg of purified water. The slurry was milled by passing it through a continuous milling machine (an Ashizawa RL12.5) with a mixing blade that turns at a peripheral velocity of 2.0 m/sec., along with 26.46 kg of zirconia beads 0.5 mm in diameter, at a supply rate of 6.09 liters per minute. Passing the slurry through the milling machine 62 times produced an aqueous slurry with a mean particle size of 323 nm, as measured by the laser diffraction method using a Mastersizer 2000 (made by Marvern). The beads were separated out using purified water, yielding 53.0 kg of an aqueous sol (11) with a pH of 8.9, an electrical conductivity of 3120 $\mu$S/cm, a viscosity of 1.4 mPa·s, and a solids content of 25.8% by weight. The resulting cerium oxide particles had a specific surface area of 20.8 m$^2$/g, as measured by the gas adsorption method (BET method), with a particle size (b2) of 40 nm, as determined from the specific surface area measured by the gas adsorption method.
The mean particle size (b1) measured by the laser diffraction method was 323 nm, and the mean particle size measured by the dynamic light scattering method was 264 nm. Therefore, the ratio of the mean particle size measured in the aqueous sol by the laser diffraction method to the particle size as determined from the specific surface area measured by the gas adsorption method was 8.1.
Ammonium polyacrylate with an average molecular weight of 1400 and purified water were added to the aqueous sols (1) to (4) used in the Examples to obtain compositions for polishing (1) to (4) for use in the Examples, each with a concentration of 1.0% by weight for the ammonium polyacrylate with an average molecular weight of 1400 and a concentration of 1.0% by weight for the cerium oxide. The mean particle size measured in the composition for polishing (1) by the laser diffraction method was 121 nm. The mean particle size measured in the composition for polishing (2) by the laser diffraction method was 127 nm. The mean particle size measured in the composition for polishing (3) by the laser diffraction method was 122 nm. The mean particle size measured in the composition for polishing (4) by the laser diffraction method was 131 nm.
L-proline and purified water were added to the aqueous sols (1) and (4) used in the Examples to obtain compositions for polishing (5) and (6) for use in the Examples, each with an L-proline concentration of 2.0% by weight and a cerium oxide concentration of 1.0% by weight. The mean particle size measured in the composition for polishing (5) by the laser diffraction method was 121 nm. The mean particle size measured in the composition for polishing (6) by the laser diffraction method was 126 nm. Also, in the compositions for polishing (1) to (6), no particles with a diameter of 1 μm or greater were present, as measured by the laser diffraction method.

Ammonium polyacrylate with an average molecular weight of 1400 and purified water were added to the aqueous sols (5) to (7) used in the Examples to obtain compositions for polishing (7) to (9) for use in the Examples, each with a concentration of 1.0% by weight for the ammonium polyacrylate with an average molecular weight of 1400 and a concentration of 1.0% by weight for the cerium oxide. The mean particle size measured in the composition for polishing (7) by the laser diffraction method was 121 nm. The mean particle size measured in the composition for polishing (8) by the laser diffraction method was 133 nm. The mean particle size measured in the composition for polishing (9) by the laser diffraction method was 141 nm.

An amino acid surface active agent (made by Toho Chemical Industry Co., Ltd.; product name: Neoscope SCT-30; active ingredient: coconut oil fatty acid sarcosine triethanolamine) and purified water were added to the aqueous sol (5) used in the Examples to obtain a composition for polishing (10) for use in the Examples, having an amino acid surface active agent concentration of 0.5% by weight and a cerium oxide concentration of 1.0% by weight. The mean particle size measured in the composition for polishing (10) by the laser diffraction method was 111 nm, and no particles with a diameter of 1 μm or greater were present.

L-alanine and purified water were added to the aqueous sol (5) used in the Examples to obtain a composition for polishing (11) for use in the Examples, having an L-alanine concentration of 4.0% by weight and a cerium oxide concentration of 1.0% by weight. The mean particle size measured in the composition for polishing (11) by the laser diffraction method was 114 nm.

Ammonium polyacrylate with an average molecular weight of 3300 and purified water were added to the aqueous sol (5) used in the Examples to obtain a composition for polishing (12) for use in the Examples, having a concentration of 1.0% by weight for the ammonium polyacrylate with an average molecular weight of 3300 and a concentration of 1.0% by weight for the cerium oxide. The mean particle size measured in the composition for polishing (12) by the laser diffraction method was 147 nm.

Ammonium polyacrylate with an average molecular weight of 1400 and purified water were added to the aqueous sols (8) to (10) used in the Comparative Examples to obtain compositions for polishing (13) to (15) for use in the Comparative Examples, each with a concentration of 1.0% by weight for the ammonium polyacrylate with an average molecular weight of 1400 and a concentration of 1.0% by weight for the cerium oxide. The mean particle size measured in the composition for polishing (13) by the laser diffraction method was 291 nm. The mean particle size measured in the composition for polishing (14) by the laser diffraction method was 120 nm. The mean particle size measured in the composition for polishing (15) by the laser diffraction method was 92 nm.

Ammonium polyacrylate with an average molecular weight of 7900 and purified water were added to the aqueous sol (11) used in the Comparative Examples to obtain a composition for polishing (16) for use in the Comparative Examples, having a concentration of 1.0% by weight for the ammonium polyacrylate with an average molecular weight of 7900 and a concentration of 1.0% by weight for the cerium oxide. The mean particle size measured in the composition for polishing (16) by the laser diffraction method was 850 nm.

Ammonium polyacrylate with an average molecular weight of 7900 and purified water were added to the aqueous sol (6) used in the Examples to obtain a composition for polishing (17) for use in the Comparative Examples, having a concentration of 1.0% by weight for the ammonium polyacrylate with an average molecular weight of 7900 and a concentration of 1.0% by weight for the cerium oxide. The mean particle size measured in the composition for polishing (17) by the laser diffraction method was 500 nm.

The aqueous sol (1) used in the Examples was diluted with purified water, without adding the component (A), to obtain a composition for polishing (18) for use in the Comparative Examples, having a cerium oxide concentration of 1.0% by weight. The mean particle size measured in the composition for polishing (18) by the laser diffraction method was 121 nm.

The aqueous sol (6) used in the Examples was diluted with purified water, without adding the component (A), to obtain a composition for polishing (19) for use in the Comparative Examples, having a cerium oxide concentration of 1.0% by weight. The mean particle size measured in the composition for polishing (19) by the laser diffraction method was 117 nm.

Evaluations of the compositions for polishing (1) to (6) and (10) to (11) for use in the Examples and the compositions for polishing (13) to (15) and (18) to (19) for use in the Comparative Examples were carried out by the method described below.

A polishing machine made by Techno Rise Co. was used. A two-layer type of abrasive cloth (one layer of abrasive cloth IC-1000 made of closed-cell urethane resin foam and another layer of non-woven cloth suba400) made by Rodale-Nitta Co. Ltd. was used. The objects polished were a plasma TEOS silicon oxide film, a high-density plasma (HDP) silicon oxide film, and a plasma silicon nitride film, each on a silicon wafer.

Polishing was done at a revolution speed of 150 rpm, a polishing pressure of 333 g/cm$^2$, and a polishing time of 3 minutes. Evaluation Item 1 was the polishing rate (Å/min.), determined by using a NanoSpec 6100 interference-type film thickness meter (made by Nanometorics) to measure, before and after polishing, the film thickness of the silicon oxide film formed by the high-density plasma CVD method.

Evaluation Item 2 was the ratio of the polishing rate for the silicon oxide film formed by the high-density plasma CVD method to the polishing rate for the silicon nitride film formed by the plasma CVD method. The polishing rates for the high-density plasma (HDP) silicon oxide film and the plasma silicon nitride film were determined by using a NanoSpec 6100 interference-type film thickness meter (made by Nanometorics) to measure the film thicknesses before and after polishing and then calculating the ratio.

Evaluation Item 3 was the result of an evaluation of the polished surface of the silicon oxide film formed by the high-density plasma CVD method. Evaluations of the silicon oxide and silicon nitride polished surfaces were done by observation under an optical microscope. When minute defects were observed, a grade of Bad was recorded, and when no defects were present, a grade of Good was recorded.

Evaluation Item 4 was the number of scratches of 0.2 $\mu m^3$ or larger per silicon wafer on which a silicon oxide film formed by thermal decomposition of tetraethoxyorthosilane (TEOS) was polished, the wafer then being washed with ammonia-containing hydrogen peroxide, followed by a wash in a 0.5% HF solution. The scratches were measured by an AWIS-15000 defect inspection apparatus (made by Optical Systems).

The polishing characteristics of a modified polishing fluid on a shallow trench isolation film were also determined, as described below.

A 1500 Å silicon nitride film was formed by the low-pressure plasma CVD method on an 8-inch silicon wafer substrate having a 3000 Å silicon oxide film on its surface. A resist was formed on the substrate, which was then exposed to light through a mask and photodeveloped to form areas with no resist. Next, the silicon nitride film and the silicon oxide film were etched in the areas without any resist, after which the resist was removed. The trench depth of the resulting pattern wafer was 3100 Å. An 8000 Å HDP oxide film was then formed on this pattern wafer by the high-density plasma CVD method to create a wafer for measuring the polishing characteristics for a shallow trench isolation film having (3140 Å) differences in level in the silicon oxide film. Polishing was then carried out under the polishing conditions described below.

A NanoSpec 6100 interference-type film thickness meter (made by Nanometorics) was used to measure the film thicknesses in the active portion and the trench portion after polishing, so as to determine the differences in level from the differences between the film thicknesses in the active portion and the trench portion.

A polishing machine made by Techno Rise Co. was used. A two-layer type of abrasive cloth (one layer of abrasive cloth IC-1000 made of closed-cell urethane resin foam and another layer of non-woven cloth suba400) made by Nitta-Haas Incorporated was used. The object polished was the wafer for measuring the polishing characteristics for a shallow trench isolation film. Polishing was done at a revolution speed of 150 rpm and a polishing pressure of 333 g/cm$^2$. The polishing time was the time required for the HDP silicon oxide film in the active portion to be removed.

Evaluation Item 5 was the polishing time (in seconds) required to polish the silicon oxide film that was formed by the high-density plasma CVD method until arrival at the silicon nitride film that was formed by the plasma CVD method, both films having been formed in the process of carrying out shallow trench isolation.

Evaluation Item 6 was the difference in level (in Å) between the silicon oxide film that was formed by the high-density plasma CVD method and the silicon nitride film that was formed by the plasma CVD method, both films having been formed in the process of carrying out shallow trench isolation.

Table 1

| Composition for polishing | Evaluation Item 1 | Evaluation Item 2 | Evaluation Item 3 |
|---|---|---|---|
| (1) | 1330 | 50 | ○ |
| (2) | 1360 | 47 | ○ |
| (3) | 1420 | 38 | ○ |
| (4) | 1470 | 42 | ○ |
| (5) | 1375 | 36 | ○ |
| (6) | 1210 | 40 | ○ |
| (10) | 1315 | 110 | ○ |
| (11) | 2312 | 34 | ○ |
| (13) | 1730 | 30 | × |
| (14) | 1010 | 17 | ○ |
| (15) | 175 | 8 | ○ |
| (18) | 4200 | 6 | ○ |
| (19) | 3500 | 8 | ○ |

Table 2

| Composition for polishing | Evaluation Item 5 | Evaluation Item 6 |
|---|---|---|
| (1) | 270 | 230 |
| (14) | 420 | 280 |

The composition for polishing (13) contains the wet-milled aqueous sol (8), in which the mean particle size measured by the laser diffraction method, 279 nm, is greater than 200 nm and the ratio of the mean particle size measured in the aqueous sol by the laser diffraction method to the particle size as determined from the specific surface area measured by the gas adsorption method is 48, a high ratio. When the composition for polishing (13) was compared to the compositions for polishing (1) and (2), which contain the aqueous sols (1) and (2), it was seen that for the composition for polishing (13), the silicon oxide/silicon nitride polishing rate selection ratio was low and minute defects also occurred in the polished surface.

The composition for polishing (14) contains the wet-milled aqueous sol (9), in which the mean particle size measured by the laser diffraction method, 115 nm, is smaller than 130 nm. When the composition for polishing (14) was compared to the compositions for polishing (1), (2), and (3), which contain the aqueous sols (1), (2), and (3), it was seen that for the composition for polishing (14), both the silicon oxide polishing rate and the silicon oxide/silicon nitride polishing rate selection ratio were lower than for the compositions for polishing (1), (2), and (3).

A comparison of the characteristics of removal of the differences in level in the shallow trench isolation film showed that the composition for polishing (1) eliminated the differences in level in the shallow trench isolation film more efficiently than did the composition for polishing (14).

The composition for polishing (15) for use in the Comparative Examples contains the wet-milled aqueous sol (10), in which the ratio of the mean particle size measured in the aqueous sol by the laser diffraction method to the particle size as determined from the specific surface area measured by the gas adsorption method is 13. When the composition for polishing (15) was compared to the compositions for polishing (1), (3), (4), and (6), which contain the aqueous sols (1), (3), and (4) used in the Examples, it was seen that for the composition for polishing (15), both the silicon oxide polishing rate and the silicon oxide/silicon nitride polishing rate selection ratio dropped by a greater amount than for the compositions for polishing (1), (3), (4), and (6).

Favorable results were obtained for the compositions for polishing (5), (6), (10), and (11) for use in the Examples, which use aqueous sols obtained in the Examples and amino acids such as proline, L-alanine, and the like, or amino acid surface active agents.

Evaluations of the compositions for polishing (7) to (9) and (12) for use in the Examples and the compositions for polishing (16) to (17) for use in the Comparative Examples were carried out by the method described below.

A polishing machine made by Strasghbaugh was used. A two-layer type of abrasive cloth (one layer of abrasive cloth IC-1000 made of closed-cell urethane resin foam and another layer of non-woven cloth suba400) made by Rodale-Nitta Co. Ltd. was used.

The objects polished were a silicon oxide film formed on a silicon wafer by thermal decomposition of tetraethoxyorthosilane (TEOS), a silicon oxide film formed on a silicon wafer by the high-density plasma CVD method, and a silicon nitride film formed on a silicon wafer by the plasma CVD method. Polishing was done at a revolution speed of 42 rpm, a polishing pressure of 210 g/cm$^2$, and a polishing time of 1 minute.

The polishing characteristics of a modified polishing fluid on a shallow trench isolation film were also determined, as described below.

A 1500 Å silicon nitride film was formed by the low-pressure plasma CVD method on an 8-inch silicon wafer substrate having a 3000 Å thermal silicon oxide film on its surface. A resist was formed on the substrate, which was then exposed to light through a mask and photodeveloped to form areas with no resist. Next, the silicon nitride film and the silicon oxide film were etched in the areas without any resist, after which the resist was removed. The trench depth of the resulting pattern wafer was 3100 Å. An 8000 Å silicon oxide film was then formed on this pattern wafer by the high-density plasma (HDP) CVD method to create a wafer for measuring the polishing characteristics for a shallow trench isolation film having (3140 A) differences in level in the silicon oxide film. Polishing was then carried out under the polishing conditions described below.

A NanoSpec 6100 interference-type film thickness meter (made by Nanometorics) was used to measure the film thicknesses in the active portion and the trench portion after polishing, so as to determine the differences in level from the differences between the film thicknesses in the active portion and the trench portion.

A polishing machine made by Strasghbaugh was used. A two-layer type of abrasive cloth (one layer of abrasive cloth IC-1000 made of closed-cell urethane resin foam and another layer of non-woven cloth suba400) made by Rodale-Nitta Co. Ltd. was used. The object polished was the wafer for measuring the polishing characteristics for a shallow trench isolation film. Polishing was done at a revolution speed of 42 rpm and a polishing pressure of 210 g/cm$^2$. The polishing time was the time required to polish the silicon oxide film formed by the high-density plasma (HDP) CVD method in the active portion until the silicon nitride film formed by the plasma CVD method appears on the surface.

Table 3

| Composition for polishing | Evaluation Item 1 | Evaluation Item 2 | Evaluation Item 3 | Evaluation Item 4 |
|---|---|---|---|---|
| 7 | 2445 | 45 | ○ | 45 |
| 8 | 1675 | 36 | ○ | |
| 9 | 2635 | 66 | ○ | |
| 12 | 2220 | 40 | ○ | |
| 16 | 2390 | 21 | × | |
| 17 | 1954 | 49 | Δ | 309 |

Table 4

| Composition for polishing | Evaluation Item 5 | Evaluation Item 6 |
|---|---|---|
| 7 | 120 | 129 |
| 8 | 180 | 80 |
| 17 | 120 | 164 |

When the composition for polishing (16) was compared to the compositions for polishing (7), (8), and (9), it was seen that the ratio of the silicon oxide polishing rate to the silicon nitride polishing rate was lower for the composition for polishing (16), in which the mean particle size measured by the laser diffraction method is 323 nm and the ratio of the mean particle size measured in the aqueous sol by the laser diffraction method to the particle size as determined from the specific surface area measured by the gas adsorption method is 8.1. Moreover, a comparison of the polishing characteristics showed that the polished surface of the silicon oxide film formed by the high-density plasma CVD method was worse for the composition for polishing (16).

When the composition for polishing (17) was compared to the compositions for polishing (7), (8), and (9), it was seen that for the compositions for polishing (7), (8), and (9), to which ammonium polyacrylate with an average molecular weight of 1400 was added, the ratio of the mean particle size measured in the compositions for polishing by the laser diffraction method to the particle size as determined from the specific surface area measured by the gas adsorption method was in the range of 1 to 4, and the state of dispersion of the polishing fluid was near monodisperse. In contrast, for the composition for polishing (17), to which ammonium polyacrylate with an average molecular weight of 7900 was added, the ratio of the mean particle size measured in the composition for polishing by the laser diffraction method to the particle size as determined from the specific surface area measured by the gas adsorption method was an extremely high 24.6, and the particles agglomerated in the polishing fluid. Also, a comparison of the polishing characteristics showed that for the compositions for polishing (7), (8), and (9), the polished surface of the silicon oxide film formed by the high-density plasma CVD method was good, the polishing rate was high, and the differences in level were eliminated efficiently on the wafer for determining the polishing characteristics on a shallow trench isolation film.

In contrast, for the composition for polishing (17), it was seen that the polished surface of the silicon oxide film formed by the high-density plasma CVD method was poor and the polishing rate was low. The polishing results for the wafer for determining the polishing characteristics on a shallow trench isolation film showed that the removal of differences in level was inferior, with a large difference in level between the silicon nitride surface and the silicon oxide surface.

Note that the composition for polishing (12) for use in the Examples, which was made by adding ammonium polyacrylate with an average molecular weight of 3300 to the aqueous sol (5) used in the Examples, exhibited good polishing characteristics.

INDUSTRIAL APPLICABILITY

The composition for polishing according to the present invention achieves good polishing characteristics as a polishing agent for a substrate having silica as its main component.

These polishing characteristics are such as to make the composition for polishing suitable to be used for planarization polishing in the semiconductor device manufacturing process that is generally called chemical mechanical polishing (CMP). In particular, because polishing can be done precisely, without inflicting damage on the silicon nitride film that is used as a protective film, the composition for polishing is useful as a polishing agent for use in a semiconductor device isolation process called shallow trench isolation (STI).

BRIEF DESCRIPTION OF THE DRAWINGS

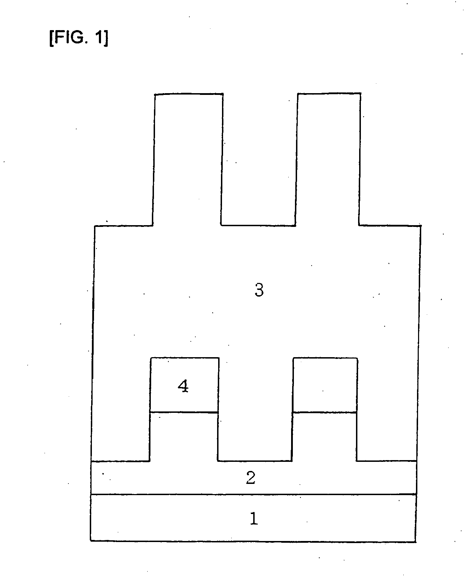

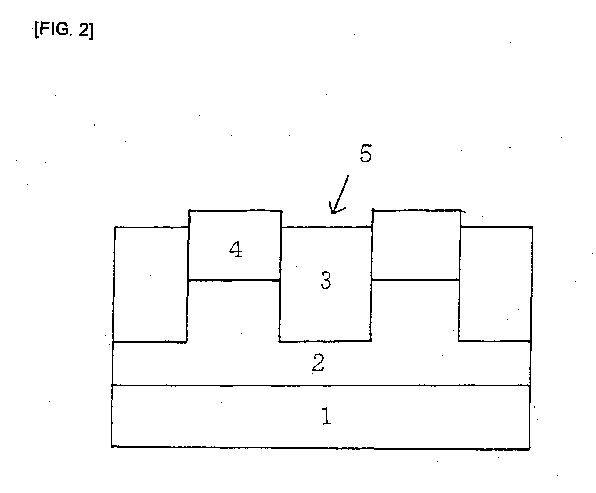

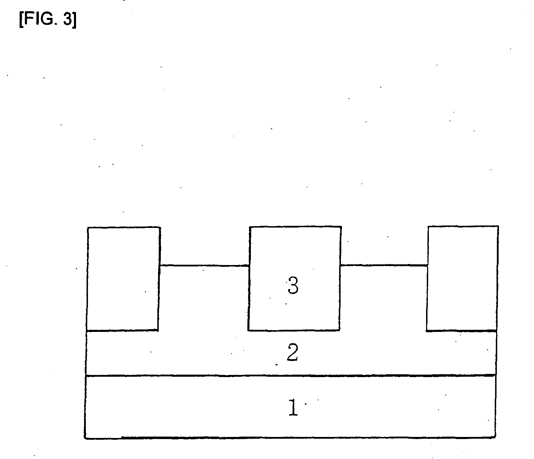

Shallow trench isolation is carried out in the sequence shown in FIGS. 1, 2, and 3.

FIG. 1 is a sectional view of a wafer on which shallow trench isolation will be carried out, prior to polishing.
FIG. 2 is a state in the process of carrying out shallow trench isolation after a silicon oxide film formed by the high-density plasma (HDP) CVD method has been polished and polishing has stopped at a silicon nitride film formed by the plasma CVD method. Differences in level exist between the silicon nitride film surface and the silicon oxide film surface.
FIG. 3 is a state in which the silicon nitride film formed by the plasma CVD method has been removed.

Description of the Reference Numerals

The reference numeral 1 denotes a silicon substrate. The reference numeral 2 denotes a thermal silicon oxide film. The reference numeral 3 denotes a silicon oxide film formed by the high-density plasma (HDP) CVD method. The reference numeral 4 denotes a silicon nitride film formed by the plasma CVD method. The reference numeral 5 denotes a difference in level that occurs between the silicon nitride film surface and the silicon oxide film surface.

**Claims**

1. A composition for polishing, comprising:

   a component (A), which is a water-soluble organic compound containing a carboxyl group or a salt thereof; and
   a component (B), which is an aqueous sol of cerium oxide particles obtained by calcining a cerium compound by holding it in at least two different calcining temperature ranges and wet-milling the resultant cerium oxide powder until the ratio of the mean particle size (b1) measured in the aqueous sol by the laser diffraction method to the particle size (b2) as determined from the specific surface area measured by the gas adsorption method is in the range of either 1 to 4 or 15 to 40, wherein
   the mean particle size measured in the composition for polishing by the laser diffraction method is 50 to 150 nm.

2. The composition for polishing according to claim 1, wherein the component (A) is a polymer component (A-1) with an average molecular weight of 1000 to 4000 that contains ammonium acrylate and/or ammonium methacrylate.

3. The composition for polishing according to claim 1, wherein the component (A) is a component (A-2) that is an amino acid or a derivative thereof.

4. The composition for polishing according to any one of the claims 1 to 3, wherein the component (B) is an aqueous sol of cerium oxide particles obtained by a process
   in which the cerium compound is calcined by holding it in two calcining temperature ranges, that is, a range of 200 to 350˚C and a range of 400 to 550˚C, and the resultant cerium oxide powder is wet-milled.

5. The composition for polishing according to any one of the claims 1 to 4, wherein the component (B) is an aqueous sol containing cerium oxide particles in which the mean particle size (b1) measured in the aqueous sol by the laser diffraction method is 80 to 130 nm, the particle size (b2) as determined from the specific surface area measured by the gas adsorption method is 3 to 10 nm, and the ratio of the mean particle size (b1) measured in the aqueous sol by the laser diffraction method to the particle size (b2) as determined from the specific surface area measured by the gas adsorption method is in the range of 15 to 40.

6. The composition for polishing according to any one of the claims 1 to 3, wherein the component (B) is an aqueous sol of cerium oxide particles obtained by a process
   in which the cerium compound is calcined by holding it in two calcining temperature ranges, that is, a range of 200 to 350˚C and a range of 700 to 850˚C, and the resultant cerium oxide powder is wet-milled.

7. The composition for polishing according to any one of the claims 1 to 3 and claim 6, wherein the component (B) is an aqueous sol containing cerium oxide particles in which the mean particle size (b1) measured in the aqueous sol by the laser diffraction method is 40 to 130 nm, the particle size (b2) as determined from the specific surface area measured by the gas adsorption method is 20 to 100 nm, and the ratio of the mean particle size (b1) measured in the aqueous sol by the laser diffraction method to the particle size (b2) as determined from the specific surface area measured by the gas adsorption method is in the range of 1 to 4.

8. The composition for polishing according to any one of the claims 1 to 7, wherein the solids content of the component (A) constitutes 0.001 to 4.5% by weight of the composition, the solids content of the component (B) constitutes 0.001 to 1.5% by weight of the composition, and the weight ratio of the component (A) solids to the component (B) solids is 0.1 to 3.0.

9. The composition for polishing according to any one of the claims 1 to 8, wherein a slurry of the cerium oxide powder in an aqueous medium is milled by a non-continuous milling apparatus using stabilized zirconia powder beads with a diameter of 0.1 to 3.0 mm, with a volumetric ratio of slurry to beads from 1:0.5 to 1:2.0.

10. The composition for polishing according to any one of the claims 1 to 8, wherein the slurry of the cerium oxide powder in an aqueous medium is milled using stabilized zirconia powder beads with a diameter of 0.03 to 1 mm and a continuous milling apparatus that is configured from a mixing blade with a peripheral velocity of 1 to 3 m/sec. and a milling vessel, the milling vessel having a volume of V liters, the flow rate of the slurry through the milling vessel being from V/4 to V liters per minute, and the volumetric ratio of slurry to beads in the milling vessel being from 1:0.5 to 1:0.9.

11. The composition for polishing according to any one of the claims 1 to 10, wherein the composition for polishing polishes a substrate having silica as its main component.

12. The composition for polishing according to any one of the claims 1 to 10, wherein the composition for polishing polishes a semiconductor device substrate on which a silicon oxide film or a silicon nitride film is formed in a pattern.

[FIG. 1]

[FIG. 2]

[FIG. 3]

<div align="center">

**INTERNATIONAL SEARCH REPORT**

</div>

| | International application No. |
|---|---|
| | PCT/JP2005/008890 |

**A. CLASSIFICATION OF SUBJECT MATTER**
Int.Cl$^7$ B24B37/00, C09K3/14, H01L21/304

According to International Patent Classification (IPC) or to both national classification and IPC

**B. FIELDS SEARCHED**

Minimum documentation searched (classification system followed by classification symbols)
Int.Cl$^7$ B24B37/00, C09K3/14, H01L21/304

Documentation searched other than minimum documentation to the extent that such documents are included in the fields searched
Jitsuyo Shinan Koho        1922-1996   Jitsuyo Shinan Toroku Koho   1996-2005
Kokai Jitsuyo Shinan Koho   1971-2005   Toroku Jitsuyo Shinan Koho   1994-2005

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| A | JP 2004-82108 A (Nissan Chemical Industries, Ltd.), 18 March, 2004 (18.03.04), Par. Nos. [0035] to [0036] & WO 2004/004910 A1 | 1-12 |
| A | JP 2001-93866 A (Speed FA Kabushiki Kaisha), 06 April, 2001 (06.04.01), Full text (Family: none) | 1-12 |
| A | JP 2000-186276 A (Hitachi Chemical Co., Ltd.), 04 July, 2000 (04.07.00), Full text (Family: none) | 1-12 |

| ☒ | Further documents are listed in the continuation of Box C. | ☐ | See patent family annex. |

| * | Special categories of cited documents: |
|---|---|
| "A" | document defining the general state of the art which is not considered to be of particular relevance |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
|---|---|
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
|---|---|
| 05 August, 2005 (05.08.05) | 23 August, 2005 (23.08.05) |

| Name and mailing address of the ISA/ | Authorized officer |
|---|---|
| Japanese Patent Office | |
| Facsimile No. | Telephone No. |

Form PCT/ISA/210 (second sheet) (January 2004)

**INTERNATIONAL SEARCH REPORT**

| International application No. |
| --- |
| PCT/JP2005/008890 |

C (Continuation).   DOCUMENTS CONSIDERED TO BE RELEVANT

| Category* | Citation of document, with indication, where appropriate, of the relevant passages | Relevant to claim No. |
| --- | --- | --- |
| A | JP 2001-2415 A  (Hitachi Chemical Co., Ltd.), 09 January, 2001 (09.01.01), Full text (Family: none) | 1-12 |

Form PCT/ISA/210 (continuation of second sheet) (January 2004)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 3278532 B
- JP 3130279 B
- JP 10152673 A
- JP 3480323 B
- JP 3462052 B

- JP 2002326812 A
- JP 10106986 A
- JP 2001031951 A
- JP 2003055648 A
- WO 2004037722 A